# EUROPEAN PATENT APPLICATION

(11) **EP 1 903 551 A1**
(43) Date of publication of application: **26.03.2008**
(21) Application number: 06254952.2
(22) Date of filing: 25.09.2006
(51) Int. Cl.: G09G 3/32

(54) **Pixel driving circuit and oled display apparatus and electronic device using the same**

(71) Applicant: TPO Displays Corp., Miao-Li County (TW)
(72) Inventor: Chang, Ting-Kuo, Hsinchu City 300 (TW); Lin, Ching-Wei, Taoyuan City Taoyuan County 330 (TW)
(74) Representative: Clarke, Alison Clare

(57) **Abstract**

A pixel driving circuit for OLED display apparatus is provided. The pixel driving circuit is adapted to drive an OLED having a first terminal and a second terminal, while the first terminal couples to a first voltage source. The pixel driving circuit comprises a control circuit, a driving transistor and a connection between the channel of the driving transistor and a second voltage source. The control circuit generates a control signal to control an OLED current supplied to the OLED. The driving transistor has a first drain/source terminal, a second drain/source terminal and a gate terminal. The gate terminal receives the control signal to control a channel between the first and second drain/source terminal for adjusting the OLED current flowing through the channel.

## Description

### BACKGROUND OF THE INVENTION

### 1. Field of the Invention

The present invention generally relates to a pixel driving circuit for OLED display apparatus, in particular, to a pixel driving circuit using 4-terminal transistor as driving transistor, and OLED display apparatus and electronic device using the same.

### 2. Description of Related Art

Being self-luminous, OLEDs eliminate the need for a backlight that is necessary in liquid crystal display devices (LCDs), and thus they are most suitable when manufacturing thinner devices. Also, the self-luminous OLEDs are high in visibility and have no limit in terms of viewing angle. These are the reasons for the attention that light emitting devices using the OLEDs are receiving in recent years as display devices to replace CRTs and LCDs.

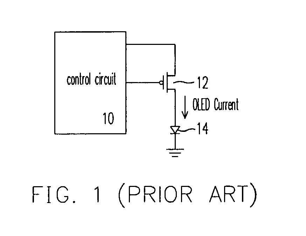

Driving circuits for an OLED display apparatus can be categorized into two kinds, i.e., voltage driving circuits and current driving circuits. However, no matter which kind of driving circuits is used, a thin-film-transistor (TFT) is used as a driving transistor for adjusting OLED current provided to the OLED. Refer to FIG. 1, a diagram shown connection structure of driving transistor and corresponding OLED in a conventional OLED pixel is provided. As shown in FIG. 1, control circuit 10 provides a control signal to control the gate terminal of the driving transistor 12 for adjusting the OLED current provided to the OLED 14. Because the driving transistor 12 is a 3-terminal device, its body is floated and the current kink effect becomes more apparent when the driving transistor 12 operates in saturation region.

Furthermore, as the driving transistor 12, for example, an p-channel TFT, operates at high drain bias condition, holes generated by hot carrier effect will accumulate at the back channel region. These accumulated holes create extra NPN BJT current. Therefore, the TFT saturation current will increases as the drain voltage. In addition, the local electric field at the drain region may become larger because of the high defect density in the polysilicon channel. This further makes the current kink effect be more serious and the brightness uniformity of OLED display apparatus is therefore affected.

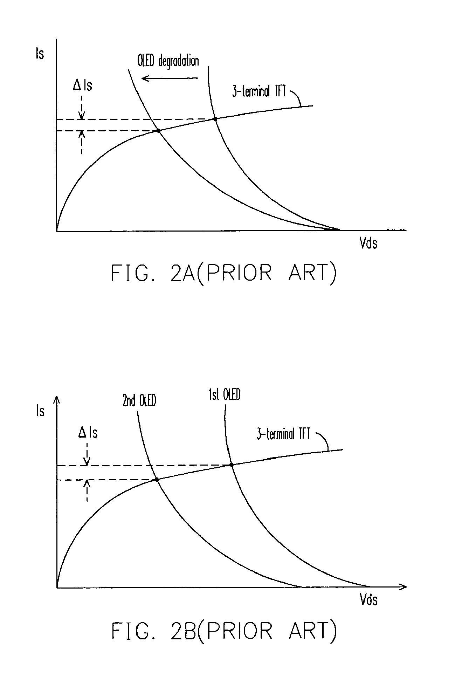

For the Active-Matrix OLED (AMOLED) panel, the brightness uniformity is influenced by three main factors, i.e. OLED reliability, OLED uniformity, and TFT characteristics variation. Refer to FIG. 2A, a curve diagram shown the influence caused by OLED reliability is provided. As well known by those skilled in the art, the OLED current becomes degraded after a certain period. This means that larger voltage is needed to apply to the OLED device to maintain the same current. As shown in FIG. 2A, as the OLED efficiency becomes degraded, the current flowing through OLED will be changed for a value Δ Is if the saturation current of driving TFT is not a constant value. In other words, not only pixel brightness but also panel gray scale will change with time when serious kink effect is observed for the driving TFT.

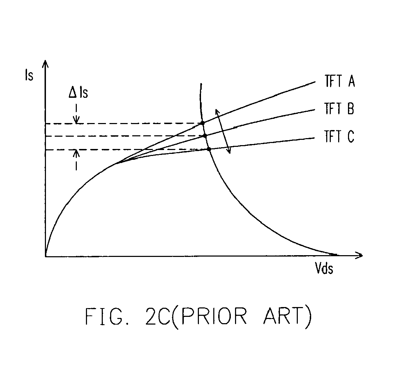

Refer to FIG. 2B, a curve diagram shown the influence caused by OLED uniformity is provided. As shown in FIG. 2B, even if the same Vgs value is given, the OLED current is also different because of the non-saturated TFT current (taking place due to kink effect). Thus, the non-uniform brightness of AMOLED panel will be observed. Further, refer to FIG. 2C, a curve diagram shown the influence caused by TFT characteristics variation is provided. Due to the process variation, the degree of kink effect in TFT A, TFT B and TFT C is also different. As illustrated in FIG. 2C, the OLED current will be dissimilar even if the turn-on characteristics of OLED devices are the same. Thus, poor brightness uniformity of AMOLED panel is obtained.

Accordingly, kink effect is an important issue for the brightness uniformity of AMOLED panel. It is therefore a necessity for reducing the kink effect taking place in the driving transistor.

### SUMMARY OF THE INVENTION

Accordingly, the present invention is directed to a pixel driving circuit for OLED display apparatus, and OLED display apparatus and electronic device using the same. By using the present invention, the kink effect is reduced such that uniformity of AMOLED panel can be improved.

In one aspect, the present invention is directed to a pixel driving circuit for OLED display apparatus. The pixel driving circuit is adapted to drive an OLED having a first terminal and a second terminal, while the first terminal couples to a first voltage source. The pixel driving circuit comprises a control circuit, a driving transistor and a diode. The control circuit generates a control signal to control an OLED current supplied to the OLED. The driving transistor has a first drain/source terminal, a second drain/source terminal and a gate terminal. The gate terminal receives the control signal to control a channel between the first and second drain/source terminal for adjusting the OLED current flowing through the channel. Further, the diode couples between the channel and a second voltage source.

According to an embodiment of the present invention, the diode comprises an intrinsic region coupling to the TFT channel and a doped region coupling to the intrinsic region, wherein the TFT channel and the doped region is doped with different types of dopant.

According to an embodiment of the present invention, the diode comprises a first region, coupled to the channel that is first-type doped; and a second region, coupled to the first region and is second-type doped. The first region is an intrinsic region or a lightly-doped region doped with the second type. When the first region is lightly-doped, the second region has higher doping concentration than the first region.

According to an embodiment of the present invention, the diode comprise a first region, coupled to the channel that is first-type doped; a second region, coupled to the first region and is second-type doped; and a third region, coupled to the second region and is second-type doped. The first region is an intrinsic region or a lightly-doped region doped with the second type. When the first region is lightly-doped, the second region has higher doping concentration than the first region. The third region has higher doping concentration than the second region.

In another aspect, the present invention is directed to an OLED display apparatus, which comprises a data driver providing a data signal, a scan driver providing a scan signal and an active area. The active area comprises a plurality of OLED pixels. At least one of the OLED pixels comprises an OLED having a first terminal and a second terminal and the first terminal coupling to a first voltage source, a control circuit generating a control signal to control an OLED current supplied to the OLED according to the data signal and the scan signal, a driving transistor and a diode. The driving transistor has a first drain/source terminal, a second drain/source terminal and a gate terminal while the gate terminal receives the control signal to control a channel between the first and second drain/source terminal for adjusting the OLED current flowing through the channel. Further, the diode couples between the channel and a second voltage source.

In still another aspect, the present invention is directed to an electronic device, which comprises a signal generator for generating image signals used for displaying an image and an OLED display apparatus provided as set forth above.

Accordingly, the kink effect caused by either holes or electrons that accumulated at the back channel region of the driving transistor can be reduced since the holes or electrons can flow outward the driving transistor via the diode coupled to the channel.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.

FIG. 1 is a diagram shown connection structure of driving transistor and corresponding OLED in a conventional OLED pixel.

FIG. 2A is a current-voltage curve diagram shown the influence caused by OLED reliability.

FIG. 2B is a current-voltage curve diagram shown the influence caused by OLED uniformity.

FIG. 2C is a current-voltage curve diagram shown the influence caused by TFT characteristics variation.

FIG. 3 is a circuitry block diagram shown an electronic device and OLED apparatus used therein according to one embodiment of the present invention.

FIG. 4A is a circuitry diagram shown a pixel driving circuit according to one embodiment of the present invention.

FIG. 4B is a circuitry diagram shown a pixel driving circuit according to one embodiment of the present invention.

FIG. 4C is a circuitry diagram shown a pixel driving circuit according to one embodiment of the present invention.

FIG. 5A is a top view shown structure of a driving transistor used in the pixel driving circuit according to one embodiment of the present invention.

FIG. 5B is a top view shown structure of a driving transistor used in the pixel driving circuit according to one embodiment of the present invention.

FIG. 6 is a layout diagram shown a pixel driving circuit according to one embodiment of the present invention.

### DESCRIPTION OF THE EMBODIMENTS

Reference will now be made in detail to the present preferred embodiments of the invention, examples of which are illustrated in the accompanying drawings. Wherever possible, the same reference numbers are used in the drawings and the description to refer to the same or like parts.

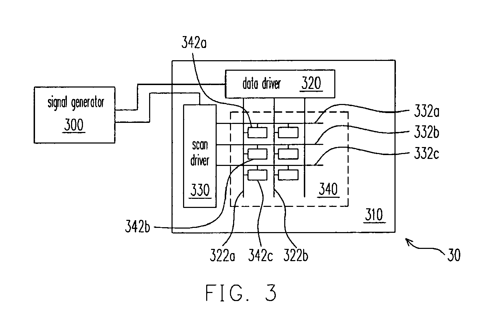

Referring to FIG. 3, which is a circuitry block diagram shown an electronic device and an OLED (Organic Light Emitting Display) apparatus used therein according to one embodiment of the present invention, the electronic device 30 comprises a signal generator 300 and an OLED display apparatus 310. The signal generator 300 generates image signals and/or control signals used for displaying an image, and sends the image signals and/or control signals to the OLED display apparatus 310.

The OLED display apparatus 310 comprises a data driver 320 for driving a plurality of data lines 322a, 322b and etc. in accordance to the image signals, a scan driver 330 for driving a plurality of scan lines 332a, 332b, 332c and etc. in accordance to the control signals, and an active area 340 comprising a plurality of OLED pixels 342a, 342b, 342c and etc. for displaying the image under control of the data lines and scan lines. For normal operation, an OLED pixel is controlled by one of the data lines and one of the scan lines. For example, OLED pixel 342a is controlled by data line 322a and scan line 332a, OLED pixel 342b is controlled by data line 322a and scan line 332b, and OLED pixel 342c is controlled by data line 322a and scan line 332c.

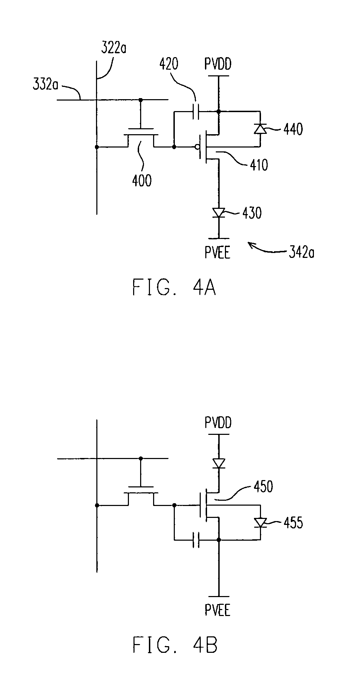

One embodiment of an OLED pixel is shown in FIG. 4A. Refer to FIG. 4A, OLED pixel 342a is controlled by the data line 322a and the scan line 332a. Moreover, the OLED pixel 342a comprises an OLED 430, a control circuit consists of switching transistor 400 and capacitor 420, a driving transistor 410 and a diode 440. It should be noted that the term "driving transistor" refers to a switch that provides current to and is capable of adjusting current flowing through the OLED.

In the embodiment, the control circuit, comprising switching transistor 400 and capacitor 420, generates a control signal in accordance to the data signal on the data line 322a and the scan signal on the scan line 332a. The control signal is sent to the gate terminal of the driving transistor 410 such that a channel between drain/source terminals of the driving transistor 410 can be controlled to adjust the OLED current flowing through the channel. Moreover, the diode 440 is coupled between the channel and a predetermined voltage source PVDD.

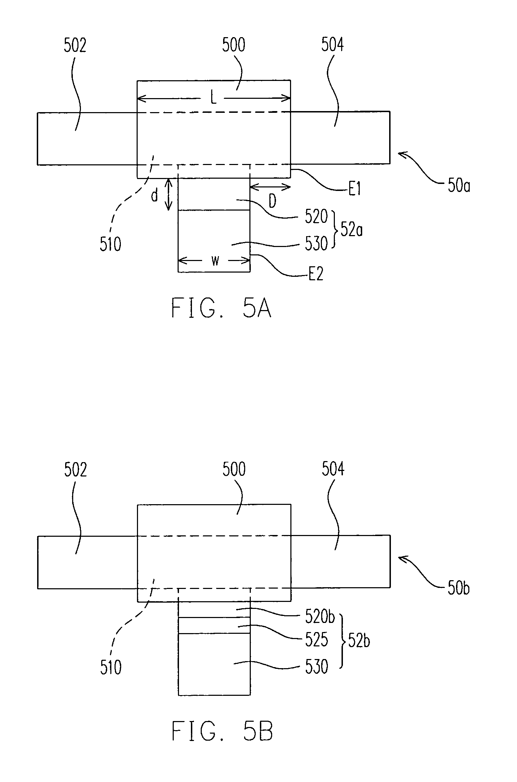

In order to make the present invention be more understandable for those with ordinary skill in the art, please refer to FIG. 5A, which is a top view shown structure of a driving transistor and a fourth terminal (a diode) used in the pixel driving circuit according to one embodiment of the present invention. In the embodiment, driving transistor 50a comprises a gate terminal 500, a source terminal 502, and a drain terminal 504. A channel 510 is formed/coupled between the source terminal 502 and the drain terminal 504.

A diode 52a can be a semiconductor diode and can serve as a fourth-terminal of the driving transistor 50a, in addition to the gate terminal 500, the source terminal 502 and the drain terminal 504. The diode 52a can include first and second regions 520 and 530, wherein the region first 520 is coupled to the channel 510. For a P-type transistor, the source terminal 502 and drain terminal 504 can be p-type doped, the first region 520 can be intrinsic or lightly doped, such as with n-type dopant, and the second region 530 can be doped with n-type dopant such that the second region 530 can have higher doping concentration than the first region 520. Similarly, for an N-type transistor, the source terminal 502 and drain terminal 504 can be n-type doped, the first region 520 can be intrinsic or lightly doped with p-type dopant, and the second region 530 can be doped with p-type dopant such that the second region 530 can have higher doping concentration than the first region 520.

The length of the diode 52a can be 0.5 um to 10 um, and can be 1 um to 6 um in some embodiments. The length of the intrinsic or lightly doped region 520, "d", can be larger than 0 um but smaller than 5 um. On the other hand, the distance "D" between the edge E1 of the gate terminal 500 and the edge E2 of the diode 52a is larger than 0 um but smaller than (L-W) um, where L is the width of the gate terminal 500 and W is the width of the diode (the fourth terminal) 52a respectively.

Although the fourth-terminal has two regions 520 and 530 in the embodiment, it is possible to include three regions in the fourth-terminal. Refer to FIG. 5B, which is a top view shown structure of a driving transistor and a fourth terminal used in the pixel driving circuit according to one embodiment of the present invention. The fourth terminal (diode) 52b includes first, second, and third regions 520b, 525 and 530. In order to maintain normal operation, the first region 520b can be intrinsic or lightly-doped. The second region 525 can be lightly-doped. The third region 530 can be heavily-doped so that the third region 530 has higher doping concentration than the second region 525. When the first region 520b and the second region 525 are lightly-doped, the second region 525 can have higher doping concentration than the first region 520b. The driving transistor 50b can be P-type or N-type.

Refer back to FIG. 5A, the diode 52a including regions 520 and 530 has two main functions. One is to enhance the degree of kink effect suppression. The other is to ensure the driving TFT device work correctly. When i (stands for intrinsic)-n⁺ (stands for highly doped with n-type dopant) diode is adopted in the device structure, the n⁺ layer (region 530) is used to reduce the conducting resistance for the electrons resulted from impact ionization. Therefore, the extra electrons can flow outward the TFT device quickly, which makes the kink effect be more unobvious. On the other hand, holes will accumulate at the channel region 510 when the device turns on. If no i or n-region 520 is inserted between the p⁺ (channel 510) and n⁺ (region 530) layers, this p⁺-n⁺ diode will conduct directly when the TFT device is at on state. The transistor behavior disappears for the driving TFT. In the embodiments of the present invention, in order to maintain the driving TFT work correctly, the i or n- region 520 is disposed.

In the embodiment, the diode 440 shown in FIG. 4A is formed by the regions 520 and 530 shown in FIG. 5A. However, the diode 440 can be a diode separated from the driving transistor.

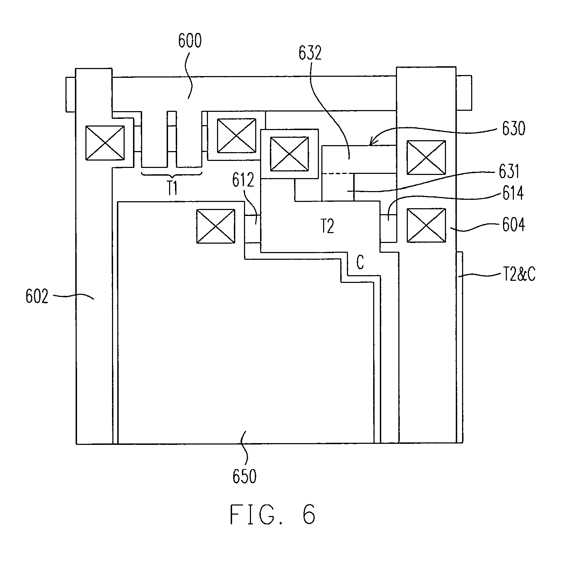

Layout of the circuitry of FIG. 4A is shown in FIG. 6. Please refer to FIG. 6, signals on the scan line 600 and data line 602 is used to control the switching transistor T1 for controlling the voltage applied to the gate of the driving transistor T2 and the capacitor C. Source terminal 614 of the driving transistor T2 and the fourth terminal 630 are coupled to the power line 604. The fourth terminal (diode) 630 includes first and regions 631 and 632. The first region 631 can be intrinsic or lightly-doped, and the second region 632 can be doped with higher doping concentration than the first region 631. The first region 631 is coupled between channel (not shown) and the second region 632, and the drain terminal 612 is coupled to a pixel electrode 650 (such as ITO).

The concept provided by the present invention can be applied to many other OLED driving circuits. Refer to FIG. 4B, which is a circuitry diagram showing a pixel driving circuit according to one embodiment of the present invention, an N-type TFT is used as the driving transistor 450, and the diode 455 are therefore connected between the channel of the driving transistor 450 and the voltage PVEE.

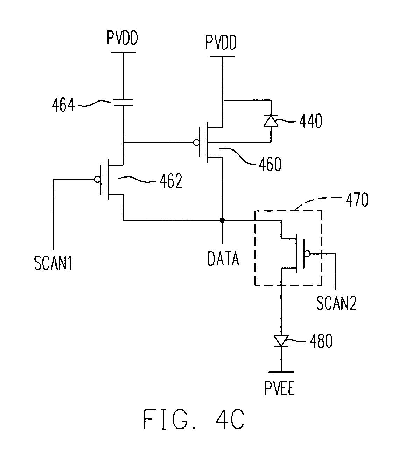

Another example is shown in FIG. 4C, which is a circuitry diagram showing a pixel driving circuit according to one embodiment of the present invention. In the embodiment, a first control circuit, comprising a switching transistor 462 and capacitor 464, is used to determine the voltage level applied on the gate terminal of the driving transistor 460 in accordance to the signal SCAN1 and DATA. However, the driving transistor 460 does not directly couple to the OLED 480. On the contrary, driving transistor 460 couples to the second control circuit, comprising a P-type transistor 470, and the second control circuit couples to the OLED 480. It should be noted that, although the transistor 470 is turned ON/OFF according to the signal SCAN2, it does not adjust current flowing through the OLED 480. In other words, the current flowing through the OLED 480 is adjusted by the voltage level applied on the driving transistor 460 while the transistor 470 functions as an ON/OFF switch only. Accordingly, transistor 460 is termed as "driving transistor" here.

It will be apparent to those skilled in the art that various modifications and variations can be made to the structure of the present invention without departing from the scope or spirit of the invention. In view of the foregoing, it is intended that the present invention cover modifications and variations of this invention provided they fall within the scope of the following claims and their equivalents.

## Claims

1. A pixel driving circuit for an organic light emitting display (OLED) apparatus, which is adapted to drive an OLED having a first terminal and a second terminal and the first terminal coupling to a first voltage source, the pixel driving circuit comprising:
a first control circuit, generating a control signal to control an OLED current supplied to the OLED;
a driving transistor, having a first drain/source terminal, a second drain/source terminal and a gate terminal, the gate terminal receives the control signal to control a channel between the first and second drain/source terminal for adjusting the OLED current flowing through the channel; and
a diode, coupling between the channel and a second voltage source.

2. The pixel driving circuit for OLED display apparatus according to claim 1, wherein the driving transistor directly couples to the second terminal of the OLED.

3. The pixel driving circuit for OLED display apparatus according to claim 1, further comprising:
a second control circuit, coupling between the driving transistor and the OLED for controlling whether the OLED current is supplied to the OLED or not.

4. The pixel driving circuit for OLED display apparatus according to claim 1, wherein the diode comprises:
a first region, coupled to the channel that is first-type doped; and
a second region, coupled to the first region and is second-type doped,
wherein the first region is an intrinsic region or a lightly-doped region doped with the second type dopants,
wherein when the first region is lightly-doped, the second region has higher doping concentration than the first region.

5. The pixel driving circuit for OLED display apparatus according to claim 4, wherein the first-type doped is N-type doped and the second-type doped is P-type doped.

6. The pixel driving circuit for OLED display apparatus according to claim 4, wherein the first-type doped is P-type doped and the second-type doped is N-type doped.

7. The pixel driving circuit for OLED display apparatus according to claim 1, wherein the diode comprises:
a first region, coupled to the channel that is first-type doped;
a second region, coupled to the first region and is second-type doped; and
a third region, coupled to the second region and is second-type doped,
wherein the first region is an intrinsic region or a lightly-doped region doped with the second type dopants,
wherein when the first region is lightly-doped, the second region has higher doping concentration than the first region,
wherein the third region has higher doping concentration than the second region.

8. The pixel driving circuit for OLED display apparatus according to claim 7, wherein the first-type doped is N-type doped and the second-type doped is P-type doped.

9. The pixel driving circuit for OLED display apparatus according to claim 7, wherein the first-type doped is P-type doped and the second-type doped is N-type doped.

10. An organic light emitting display (OLED) apparatus, comprising:
a data driver, providing a data signal;
a scan driver, providing a scan signal; and
an active area comprising a plurality of OLED pixels, wherein at least one of the OLED pixels comprises:
an OLED, having a first terminal and a second terminal and the first terminal coupling to a first voltage source;
a control circuit, generating a control signal to control an OLED current supplied to the OLED according to the data signal and the scan signal;
a driving transistor, having a first drain/source terminal, a second drain/source terminal and a gate terminal, the gate terminal receives the control signal to control a channel between the first and second drain/source terminal for adjusting the OLED current flowing through the channel; and
a diode, coupling between the channel and a second voltage source.

11. An electronic device, comprising:
a signal generator, generating image signals used for displaying an image; and
an organic light emitting display (OLED) apparatus, comprising:
a data driver, providing a data signal according to the image signals;
a scan driver, providing a scan signal; and
an active area, comprising a plurality of OLED pixels for displaying the image, wherein at least one of the OLED pixels comprises:
an OLED, having a first terminal and a second terminal and the first terminal coupling to a first voltage source;
a control circuit, generating a control signal to control an OLED current supplied to the OLED according to the data signal and the scan signal;
a driving transistor, having a first drain/source terminal, a second drain/source terminal and a gate terminal, the gate terminal receives the control signal to control a channel between the first and second drain/source terminal for adjusting the OLED current flowing through the channel; and
a diode, coupling between the channel and a second voltage source.
